# EUROPEAN PATENT APPLICATION

(11) **EP 2 765 413 A1**
(43) Date of publication of application: **13.08.2014**
(21) Application number: 13154988.3
(22) Date of filing: 12.02.2013
(51) Int. Cl.: G01N 27/34, G01N 27/48, G01Q 60/60, G01Q 60/24

(54) **AFM probe integrated dropping and hanging mercury electrode**

(71) Applicant: UNIVERSITEIT TWENTE, 7522 NB Enschede (NL)
(72) Inventor: Schön, Peter Manfred, 7522 NB Enschede (NL); Geerlings, Joël, 7522 NB Enschede (NL); Sarajlic, Edin, 7522 NB Enschede (NL); Tas, Niels Roelof, 7522 NB Enschede (NL)
(74) Representative: Ellens, Andries

(57) **Abstract**

The application describes apparatus and methods for performing a dropping mercury based process on a microscopic scale, using an AFM (atomic force microscopy) setup (300) with an AFM cantilever (110) comprising a micro-channel (120) with a cantilever micro-channel outlet (121) for growing a mercury droplet (51), and guiding mercury through the micro-channel to provide the mercury droplet at the cantilever micro channel outlet, wherein the cantilever micro channel outlet has an channel outlet hydraulic diameter selected from the range of 1 nm - 10 µm, and wherein the micro channel of the AFM cantilever has a hydraulic diameter in the range of 1 nm - 100 µm.

## Description

### FIELD OF THE INVENTION

The invention relates to a method of performing a dropping mercury based process, the use of such method (or process) for a number of applications, an AFM setup comprising an AFM cantilever comprising a channel, to a dropping mercury electrode system, as well to the use of such AFM cantilever comprising a channel or dropping mercury electrode system for a number of applications.

### BACKGROUND OF THE INVENTION

Dropping mercury electrodes (DME) are known in the art. EP0332125, for instance, describes a mercury drop electrode for use in electrochemical experiments. EP0332125 includes a reservoir for liquid mercury, a mercury drop capillary having upper and lower open ends and also having a chemically inert lower capillary tube portion and an electrically conductive upper capillary tube portion supported by the lower portion and in contact with the mercury in the reservoir, valve means including a valve stem having a seal at its lower end and a ferromagnetic portion at its upper end, a valve seat comprising the upper end of the upper portion of the capillary which acts in concert with the valve seal to close the valve, and actuating means operatively arranged to lift the valve seal from the seat to allow mercury to enter the capillary from the reservoir and to lower the seal to the seat to prevent mercury from entering the capillary from the reservoir.

In general, for DME systems a fine capillary is connected to a reservoir of mercury. The system is designed so that mercury is allowed to flow down the capillary at a controlled rate and out into the solution. Electrical contact to the mercury is made in the reservoir and a reference and counter electrode are arranged in the electrolyte solution. Voltammetry can performed in an identical manner to that described earlier, however, now the electrode is constantly changing area and so a linear sweep voltammogram will exhibit significantly different behavior. As the mercury drop grows the surface area accessible to the electrolyte also increases and consequently the current increases. However, at some point the Mercury drops from the tip leaving a small new area in contact with the electrolyte, consequently the current drops rapidly at this point before gradually increasing as the drop grows again. This behavior is repeated throughout the scan.

### SUMMARY OF THE INVENTION

Classic dropping mercury electrodes cannot (easily) cope with situations wherein electrochemical/electrical properties are altered by force. Also, applications like mercury lithography (or amalgam lithography) may not be possible with classic dropping mercury electrodes.

Hence, it is amongst others an aspect of the invention to provide an alternative type of dropping mercury process and/or an alternative type of dropping mercury electrode, which preferably further at least partly obviate one or more of above-described drawbacks. Herein, the terms "dropping mercury process" or "dropping mercury electrode", and similar terms, refer to applications and configurations wherein droplets drip from the electrode as well as wherein a droplet hangs at the electrode. In other words, herein the term "dropping mercury electrode", and similar terms, may also relate to a hanging mercury electrode.

We report here a novel type of "dropping/hanging-like" mercury electrode which is integrated into an AFM tip and cantilever. Our approach is based on a fountain pen probe with appropriate dimensions enabling filling with mercury under changing the applied pressure at a connected mercury supply. The fountain pen probe utilizes a special design with vertical pillars inside the channel to minimize mechanical perturbation. Dropping and hanging mercury drop at the AFM tip were observed as function of the applied pressure at the external mercury supply. The mercury flows through the hollow cantilever and forms drops of the size of (e.g.) ≥ 4 µm. The flow can be stopped under reduction of pressure and can be operated in hanging (HMDE) drop or continuously dropping configuration (DME). The hollow probe shows excellent isolation and electrical conductivity only occurs through the mercury. Electrical conductivity occurred only through the mercury after filling and the empty fountain pen probe showed excellent electrical insulation. This was demonstrated by chronoamperometric measurements in electrolyte, as well as by mechanical and electrical contacting of an ITO substrate with a mercury filled and empty probe in air. Finally, cyclic voltammetry was done at a hanging mercury drop at the fountain pen aperture, demonstrating the principle usability of the mercury probe for electrochemical studies.

Prior art mercury microelectrodes need ex-situ preparation before each measurement. Furthermore, operation in a dropping mercury electrode is excluded. Our approach comprises an in-situ renewable mercury electrode integrated into an AFM cantilever. It is based on a fountain pen probe and it contains an integrated channel to transport fluid from the base of the AFM probe to the tip (or other opening at the cantilever distal end), across the flexible cantilever beam. Applications include patterned SAM (self-assembled monolayer) deposition, nano-electrochemical metal deposition, gold particle deposition, deposition and patterning of DNA and electric field induced delivery of proteins.

Here we utilize a fountain pen probe of specific design including internal vertical pillars for mechanical stabilization for the use as dropping and hanging mercury electrode. In addition to the internal pillars, the fountain pen probe channel height was decreased, while the wall thickness was increased, to lower the liquid mercury pressure in the setup and to further mechanically stabilize the probe for working pressures of ~ 6 bars or even higher.

Integrating a mercury electrode into an AFM cantilever has the advantage of being able to measure simultaneously electrochemical/electrical properties and forces. This is of particular interest in particle electrochemistry or in case when electrochemical/electrical properties are altered by force. From the point of view of the AFM probe it offers the possibility of an integrated renewable electrochemical electrode.

Hence, the invention allows new methods for performing a dropping mercury based (chemical) process. For instance, the method (as described herein) and/or the new AFM setup and/or the new AFM cantilever may be used for one or more applications selected from the group consisting of (1) probing conductivity of a heterogeneous substrate, (2) Hg lithography, (3) electrochemically probing a local concentration of a specie, such as a metal ion (i.e. corrosion), an organic molecule (volatiles) and particles, and (4) simultaneously electrochemical probing and atomic force probing of a surface. Further, the invention may allow to probe membrane electrochemical properties of mitochondria, to study the electrochemistry of a particle, a droplet, or a vesicle, liposome (or other type of biomolecule) adhesion and/or interaction to a mercury electrode, etc.

Hence, the invention may provide an in-situ renewable liquid metal electrode for liquid metal droplets of very small dimensions, optionally in combination with (atomic) force measurement. Not only mercury may be applied, but e.g. also eutectic GaIn or Ga (see further also below). The method and apparatus of the invention may allow e.g. also lithographic applications.

In a specific application, the invention may also be applied to provide an Hg colloidal probe with adjustable surface energy to probe surface charges/mechanical properties. Colloidal probes attached to AFM cantilevers are frequently used to probe mechanical properties of surfaces and materials. Now, we can generate a stable Hg drop at an AFM tip to which we can apply a potential. By this the surface energy of the droplet can be very precisely adjusted. For instance, adhesive properties of surfaces may be proved. With this approach one might map the surface charge distribution on e.g. cellar membranes, for instance which is crucial for state of health and disease of a cell. Also, it might open novel horizons in soft matter mechanical characterization including gels as well.

For instance, probing conductivity of a heterogeneous substrate may be done by mechanically contacting the surface ("voltmeter), while mapping the distribution of local conductivities at the surface with the AFM probe. In this way, the distribution of local conductivities might be quantified. Mercury (Hg) lithography or amalgam lithography may be performed by applying with the method or AFM setup droplets of mercury on a surface that can react with mercury to form an amalgam. In fact, the AFM setup can be used as a kind of inkjet printer, to write mercury on a surface.

Further, probing the presence and/or local concentration of a specie may be done by electroanalytical techniques, such as voltammetry or stripping voltammetry or chrono amperometry. Characteristic species may for instance be selected from the group comprising metal ion (i.e. corrosion), organic molecules (volatiles) and micro and nanoparticles.

In addition, simultaneously electrochemical probing and atomic force probing of a surface may be performed by contacting the surface or particle of interest followed by an electrochemical measurement under remaining in contact and/or variation of the contacting force.

In principle, the AFM setup and method of the invention may also be applied for other metal, or ionic liquids, or conductive compounds, that can be liquidified, especially up to temperatures of about 375 °C, especially up to a temperature of about 300 °C, even more especially up to 250 °C, such as up to about 150 °C. Examples are mercury, eutectic gallium indium, gallium, Wood's metal (in the art also indicated to be an eutectic alloy of 50% bismuth, 26.7% lead, 13.3% tin, and 10% cadmium by weight, with a melting point of approximately 70 °C (158 °F)), Rose's metal (in the art also indicated to consist of 50% bismuth, 25-28% lead and 22-25% tin; its melting point is between 94 °C (201 °F) and 98 °C (208 °F).), Field's metal (in the art also indicated to be Field's alloy; it is a fusible alloy that becomes liquid at approximately 62 °C (144 °F); it is an eutectic alloy of bismuth, indium, and tin, with the following percentages by weight: 32.5% Bi, 51% In, 16.5% Sn.), Cerrosafe (a bismuth, lead, tin, indium alloy; in the art, Cerrosafe is known to be a non-eutectic alloy with a yield temperature of 162.5° F; also known to have a composition of Tin 11.3%, Bismuth 42.5% Lead 37.7% Cadmium 8.5%), Cerrolow 136 (in the art known to be an eutectic alloy with a melting temperature of 136° F; also known to have a composition of Tin 12% Bismuth 49% Lead 18% Indium 21%), Cerrolow 117 (in the art known to be an eutectic alloy with a melting temperature of 117° F; also known to have a composition of Tin 8% Bismuth 4.7% Lead 22.6% Cadmium 5.3% Indium 19.1%), Bi-Pb-Sn-Cd-In-Tl, other alloys having a melting temperature below 300 °C, especially having a melting temperature below 200 °C, such as mercury-containing alloys, only alkali metal-containing alloys, gallium-containing alloys (but neither alkali metal nor mercury), only bismuth, lead, tin, cadmium, zinc, indium and sometimes thallium-containing alloys, other alloys. For instance, many if not all of the Indalloy® alloys may be suitable.

In a first aspect, the invention provides a method of performing a dropping mercury based process on a microscopic scale, the method comprising providing an AFM (atomic force microscopy) setup with an AFM cantilever ("cantilever") comprising a micro channel with a cantilever micro channel outlet ("outlet") for growing a mercury droplet, and guiding mercury, especially under a pressure ≥ 1 bar, such as 1-100 bar, like at least 2 bar, such as at least 4 bar, such as in the range of 5-100 bar, through the micro channel to provide the mercury droplet at the cantilever micro channel outlet, wherein the cantilever micro channel outlet has an channel outlet hydraulic diameter, which may especially be selected from the range of 1 nm - 10 µm, and wherein the micro channel of the AFM cantilever may especially have an hydraulic diameter in the range of 1 nm - 1 mm, such as especially 1 nm - 100 µm, like especially at least 10 nm.

The mercury droplet has mercury droplet dimensions, which are general indicated by a radius or diameter. In an embodiment, the droplets may have maximum diameters in the range of 4-50 µm Hence, the method may include forming a mercury droplet at the micro channel outlet wherein the mercury droplet thus formed may have dimensions in the range of 4-50 µm. Note that during the method the droplet will grow to this size. Advantageously, the dimensions of the droplet may be controlled by amongst others the pressure. This may e.g. be of interest when probing conductivity of a heterogeneous substrate by mechanically contacting the surface. Alternatively or additionally, when desired the droplet can be refreshed, to provide an entirely fresh droplet (electrode surface in case electrochemistry is applied). Especially, the micro channel is part of a fluid system, wherein the fluid system further comprises a first electrode configured to be in contact with the mercury in the fluid system during operation of the AFM setup, and wherein by controlling the pressure one or more of (a) the mercury droplet can be removed from the micro channel outlet and replaced by a new mercury droplet, and (b) the dimensions of the mercury droplet can be controlled.

More generally, the invention provides a method of performing a dropping liquid metal or metal alloy based process on a microscopic scale, the method comprising providing an AFM (atomic force microscopy) setup with an AFM cantilever ("cantilever") comprising a micro channel with a cantilever micro channel outlet ("outlet") for growing a metal or metal alloy droplet, and guiding metal or metal alloy, especially under a pressure ≥ 1 bar, such as 1-100 bar, like 5-100 bar, through the micro channel to provide the mercury droplet at the cantilever micro channel outlet, wherein the cantilever micro channel outlet has an channel outlet hydraulic diameter, which may especially be selected from the range of 1 nm - 10 µm, and wherein the micro channel of the AFM cantilever may especially have an hydraulic diameter in the range of 1 nm - 1 mm, such as especially 1 nm - 100 µm, such as at least 10 nm. Further, the principle of the invention may not only be applied to AFM type of applications, but may also be applied to other type of applications, like STM (scanning tunneling microscopy), with a mercury droplet as conductive tip, and other applications.

The AFM cantilever has a micro channel with (cantilever) micro channel outlet, both having specific hydraulic diameters. The micro channel (within the cantilever) runs through a substantial part of the cantilever, especially over the entire length of the cantilever. The channel outlet is especially close to the distal end of the cantilever, i.e. remote from the end that is closer to the probe head or cantilever head. Herein, the term "hydraulic diameter" is applied, as the channel(s) or outlet(s) may not necessarily have circular perimeters (or cross sections). The term "hydraulic diameter" is a commonly used term when handling flow in non-circular tubes and channels. Using this term one can calculate the "effective" diameter in the same way as for a round tube. The hydraulic diameter is defined as Dₕ=4A/P, where A is the cross sectional area and P is the (wetted) perimeter of the cross-section. Herein, simply the perimeter is chosen. For a circular cross-section, Dₕ=D.

In yet a further aspect, the invention provides an AFM setup comprising an AFM cantilever comprising a micro channel, with a cantilever micro channel outlet for growing a mercury (or other liquid metal or metal alloy) droplet, wherein the cantilever micro channel outlet has an channel outlet hydraulic diameter, especially selected from the range of 1 nm - 10 µm, especially at least 10 nm, and wherein the micro channel of the AFM cantilever may especially have an hydraulic diameter in the range of 1 nm - 100 µm, wherein the micro channel is part of a fluid system, wherein the fluid system further comprises a vessel configured to contain mercury (or other liquid metal or metal alloy), and wherein the AFM setup further optionally comprises a pressure generator, configured to guide mercury (or other liquid metal or metal alloy), especially under a pressure of ≥ 1 bar, through the micro channel to provide the mercury (or other liquid metal or metal alloy) droplet at the cantilever micro channel outlet. Hence, the pressure generator is especially configured to guide the mercury through the fluid system in a direction from the vessel to the channel outlet at the cantilever. Further, the pressure generator is especially configured to control stop and flow of the mercury enabling hanging drop configuration as well.

In yet a further aspect, the invention provides an AFM probe integrated dropping mercury (or other liquid metal or metal alloy) electrode system ("system") comprising the AFM setup as defined herein, a counter electrode, a reference electrode, a voltage source in electrical connection with a first electrode (during operation of the AFM probe integrated dropping mercury (or other liquid metal or metal alloy) electrode system in electrical connection with the mercury (or other liquid metal or metal alloy) within the fluid system) and the counter electrode, and a sensor configured to measure an electronic parameter selected from the group consisting of resistance, current and electrical potential difference between the first electrode and the reference electrode.

The invention may now advantageously allow electrochemical AFM, conductive AFM, electrochemical analysis, molecular electronics (e.g. measure conductivity of molecules/molecular layers), and mechano-electro(chemistry) (e.g. measure electrical/electrochemical properties as function of force), etc.

As indicated in the background of the invention, dropping mercury systems are known in the art. Especially, dropping mercury electrodes, a dropping mercury system, with an electrode in electrical contact with mercury. The present AFM cantilever may be used for both electrochemical as non-electrochemical applications. Further, the setup and/or the process may be used in both dropping (DME) or hanging dropping mercury electrode (HDME) applications (or other liquid metal or metal alloy). Here, the AFM may allow dropping mercury (or other liquid metal or metal alloy) based processes, wherein the droplets may have maximum diameters in the range of 4-50 µm, such as 8-40 µm Therefore, the dropping mercury (or other liquid metal or metal alloy) based processes are herein indicated to be applicable on a microscopic scale. Advantageously, such scales allow new type of processes/methods, like described above.

Atomic force microscopy (AFM) is known in the art. In the present invention a cantilever with or without a tip can be used. Further, the method and/or process will in general be applied in a non-contact mode; i.e. the cantilever, or its tip - when present - does not contact the sample under investigation. Especially, this may of interest when applying scanning or imaging with the AFM setup or method of the invention. However, when applying force probing, a contact mode may also be applied.

When using a tip, the tip is generally made of silicon or silicon nitride. The tips come in various shapes. The end of this tip is often slightly rounded, being around ten nanometers (0.00001 millimeters, or about 100 atoms) in radius. The tip may also be cylindrical. The tip has a channel (or other volume) which is in fluid contact with the micro channel in the cantilever. The tip can be elongated, but may in an embodiment also be a (small) chamber with an outlet (the micro channel outlet). At the tip, the micro channel outlet is found. The outlet is not necessarily at an apex, but may be arranged anywhere at the tip (which will in general have a pyramidal shape). When however no tip is used, the micro channel outlet is part of the cantilever ("fountain pen probe"). Hence, in an embodiment a tip may be applied, with an aperture or micro channel outlet. This outlet may be at the apex, but may also be at an edge.

The cantilever is thin, flexible beam, or "cantilever". Its shape is usually triangular ("V" shaped) or long and rectangular (an "I" beam). In the experiments described below, a rectangular type cantilever has been applied.

These are roughly 100-200 microns long and only a few microns thick, such as 2-10, like about 4 µm This makes them very flexible but strong enough to securely hold the tips on their end. The width may for instance be in the range of 20-40 µm. For most AFM, the height of the tip (and therefore sample) is usually monitored using a laser beam which reflects off the backside of the cantilever (a gold coating on the cantilever makes it behave like a mirror). This reflected beam hits a multi-segment photodiode which can detect the movement of the beam, and therefore the movement of the cantilever and tip. The vertical movement of the tip is thereby measured as a voltage change.

Herein, the term "AFM setup" may refer to any setup that may be used for AFM measurements. Relevant for the invention is however that the cantilever has a micro channel that can be filled with mercury (or other liquid metal or metal alloy) and the cantilever has an outlet (optionally at a cantilever tip), that allows generation of mercury (or other liquid metal or metal alloy) droplets, when mercury (or other liquid metal or metal alloy) is guided under pressure through the micro channel. Hence, the cantilever that is used herein, comprises a micro channel, which may be present over a substantial part of the cantilever arm. The length of the channel in the cantilever (including arm) may for instance be in the range of about 50-180 µm. In general, over about 60-90% of the length of the arm, the micro channel will be present. This micro channel may have a square, rectangular, round, oval, etc. cross-section, but will in general have a rectangular cross-section. The microchannel has a channel axis, parallel to a mercury flow direction (during a flow of mercury through the micro channel). The cross-section is perpendicular to this channel axis. The perimeter of the micro channel may vary over the length. However, within the channel arm, the perimeter will in general in the range of 4 nm - 100 µm. Hence, the micro channel of the AFM cantilever may especially have an hydraulic diameter in the range of 1 nm - 100 µm, especially at least 100 nm, such as at least 1 µm, like in the range of 10-50 µm. Outside these ranges, pressure problems may arise. The terms "cantilever micro channel" and "micro channel" thus especially refer to the micro channel in the cantilever arm. Optionally, the cantilever comprises more than one arm, each having a micro channel.

Cantilevers like this can e.g. be made by microsystem clean room technologies, which are known in the art, like thin film deposition, photolithographic patterning, etching, sacrificial layer etching to form the micro channel, etc.

It especially appears advantageously when the micro channel of the AFM cantilever is at least partly coated with a fluorocarbon, such as Teflon, coating. Amongst others, this may decrease undesired electro wetting effects. Other coatings might also be applied, such as silicone coatings. Such coatings within the micro channel can be made by a gas phase deposition. The coating may be applied to at least part of the internal of the channel, but also to at least part of the exterior of the cantilever. Due to the fact that the fluorocarbon, such as Teflon" or other type of coating, may include a gaseous process, bot the interior and exterior may be coated with fluorocarbon, such as Teflon, or other coatings.

In yet another embodiment, the micro channel may comprise a coating with an electrically conductive material, especially a metal coating. An advantage may be that wetting with e.g. mercury may be enhanced. Further, the metal coating may also be applied as (part of) the (first) electrode.

In a specific embodiment, the micro channel of the AFM cantilever comprises internal reinforcing bars arranged perpendicular to a channel axis of the micro channel. Especially, these bars may bridge the height of the micro channel. Such micro channels with reinforcing bars may for instance be made by etching holes in the sacrificial layer prior to deposition of the channel capping thin film. In a specific embodiment, the 10-80 vol.%, such as 20-70 vol.% of the micro channel (to obtain the micro channel volume, the cross-sectional area is multiplied with the channel length) is occupied with such bars. The bars may have widths in the range of 0.1-10 µm, especially 1-5 µm, like 1-2.5 µm. Also the bars may be coated with a (fluorocarbon, such as Teflon,) coating.

Close to one end of the cantilever (the measuring end or downstream end; farthest away from the connection(s) to the rest of the AFM setup, such as the AFM head) the channel outlet or channel aperture is found. In general, this outlet will be a circular outlet, having a channel outlet hydraulic diameter of 1 nm - 10 µm, especially 100 nm - 10 µm. Assuming a circular opening, the channel outlet hydraulic diameter equals the diameter. Assuming a non-circular outlet or apertures, the channel outlet hydraulic diameter can be defined as a channel outlet effective or hydraulic diameter which equals the aperture perimeter divided by π. Hence, the perimeter of the outlet will in general be in the range of πd, with d especially being 1 nm - 10 µm, especially 4 nm - 10 µm, such as 100 nm - 10 µm

In an embodiment, the method involves comprising guiding mercury under a pressure of at least 4 bar, especially in the range of 5-100 bar, through micro channel. Pressure may be applied with a pressure generator, such as a pump. For instance, a syringe pump can be applied.

The AFM setup may comprise a fluid system of which the micro channel is part. This fluid system may comprise a vessel that may be configured to contain mercury. This vessel is especially in fluid communication with the fluid system. This vessel is further especially in fluid communication with the cantilever micro channel and channel outlet. Further, this fluid system may contain channels for fluid, in fluid communication with the cantilever micro channel. Note that the cantilever micro channel is also part of the fluid system. By applying pressure on the mercury in the fluid system, such as by applying pressure on the mercury in the vessel, mercury may escape via the channel outlet. Pressure may be applied continuously or in a pulsed way. Optionally there is a pressure of over 1 bar, such as at least 4 bar, with optionally a variation in time thereon. For small perimeters, like e.g. 10 nm, this pressure may even be higher. In an embodiment a pressure of in the range of 25-100 bar, such as 50-100 bar may be applied.

For applications wherein electrical conductivity is important, such as when applying the cantilever as a dropping mercury electrode, the fluid system will also comprise an electrode. During use of the AFM setup, mercury is within the fluid system and thus in contact with the electrode. This electrode is indicated as first electrode. Hence, in a further embodiment the dropping mercury based process is an electrochemical process, and wherein the micro channel is part of a fluid system, wherein the fluid system further comprises a first electrode. Therefore, the fluid system may further comprise a first electrode, configured to be in electrical contact with mercury when mercury is in the fluid system. Especially, the first electrode is configured to be in contact with the mercury in the fluid system during operation of the AFM setup (in an electrochemical process).

As indicated above, the invention also provides an AFM setup comprising an AFM cantilever comprising a micro channel, with a cantilever micro channel outlet for growing a mercury droplet, wherein the cantilever micro channel outlet has an channel outlet hydraulic diameter (d), especially selected from the range of 1 nm - 10 µm, and wherein the micro channel of the AFM cantilever may especially have an hydraulic diameter in the range of 1 nm - 100 µm, wherein the micro channel is part of a fluid system, wherein the fluid system further comprises a vessel configured to contain mercury, and wherein the AFM setup further optionally comprises a pressure generator, configured to guide mercury, especially under a pressure of > 1 bar, through the micro channel to provide the mercury droplet at the cantilever micro channel outlet. The vessel may e.g. be integrated in the probe head. Optionally, there may be a plurality of vessels, e.g. integrated in the probe head and a (larger) vessel or reservoir between the pressure generated and the vessel integrated in the probe head. The pressure generator may e.g. be a syringe pump, though other type of pressure generators may also be applied.

In yet a further aspect, the invention provides an AFM probe integrated dropping mercury electrode system comprising the AFM setup as defined herein, a counter electrode, a reference electrode, a voltage source in electrical connection with a first electrode (during operation of the AFM probe integrated dropping mercury electrode system in electrical connection with the mercury within the fluid system) and the counter electrode, and a sensor configured to measure an electronic parameter selected from the group consisting of resistance, current and electrical potential difference between the first electrode and the reference electrode. The voltage source may especially be configured to generate voltages in the range of +/- 32 volts, e.g. in the range of +/- 2 volts. Further, the sensor may especially be configured to measure at least a potential difference and/or current, e.g. for voltammetry. The voltage source and sensor may also be one apparatus, such as the working electrode in a Scanning Electrochemical Microscopy (SECM). Especially, a control unit may be applied, that is able to provide one or more functions of a voltage source and voltage sensor and/or current sensor, and especially may also be able to control the AFM setup or AFM system, respectively.

The terms "upstream" and "downstream" relate to an arrangement of items or features relative to the propagation of the mercury from a mercury supplying means (here the e.g. the vessel with mercury, which optionally due to application of pressure on the mercury provides a mercury flow), wherein relative to a first position within a beam of mercury from the mercury supplying means, a second position in the beam of mercury closer to the mercury supplying means is "upstream", and a third position within the beam of mercury further away from the mercury supplying means is "downstream".

The term "substantially" herein, such as in "substantially all emission" or in "substantially consists", will be understood by the person skilled in the art. The term "substantially" may also include embodiments with "entirely", "completely", "all", etc. Hence, in embodiments the adjective substantially may also be removed. Where applicable, the term "substantially" may also relate to 90% or higher, such as 95% or higher, especially 99% or higher, even more especially 99.5% or higher, including 100%. The term "comprise" includes also embodiments wherein the term "comprises" means "consists of".

The devices or apparatus herein are amongst others described during operation. As will be clear to the person skilled in the art, the invention is not limited to methods of operation or devices in operation.

It should be noted that the above-mentioned embodiments illustrate rather than limit the invention, and that those skilled in the art will be able to design many alternative embodiments without departing from the scope of the appended claims. In the claims, any reference signs placed between parentheses shall not be construed as limiting the claim. Use of the verb "to comprise" and its conjugations does not exclude the presence of elements or steps other than those stated in a claim. The article "a" or "an" preceding an element does not exclude the presence of a plurality of such elements. The invention may be implemented by means of hardware comprising several distinct elements, and by means of a suitably programmed computer. In the device claim enumerating several means, several of these means may be embodied by one and the same item of hardware. The mere fact that certain measures are recited in mutually different dependent claims does not indicate that a combination of these measures cannot be used to advantage.

The invention further applies to an apparatus or device comprising one or more of the characterizing features described in the description and/or shown in the attached drawings. The invention further pertains to a method or process comprising one or more of the characterising features described in the description and/or shown in the attached drawings.

The various aspects discussed in this patent can be combined in order to provide additional advantages. Furthermore, some of the features can form the basis for one or more divisional applications.

### BRIEF DESCRIPTION OF THE DRAWINGS

Embodiments of the invention will now be described, by way of example only, with reference to the accompanying schematic drawings in which corresponding reference symbols indicate corresponding parts, and in which:
Figs. 1a-1b schematically depict some aspects of an AFM setup and a AFM probe integrated dropping mercury electrode system;
Figs. 2a-2e schematically depict some aspects of the cantilever;
The drawings are not necessarily on scale;

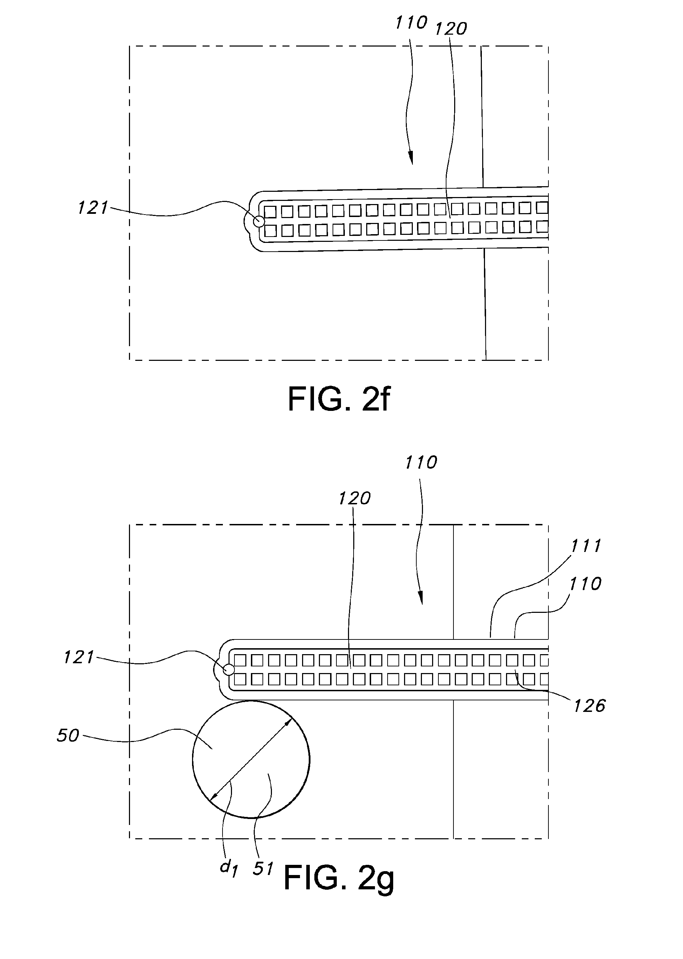

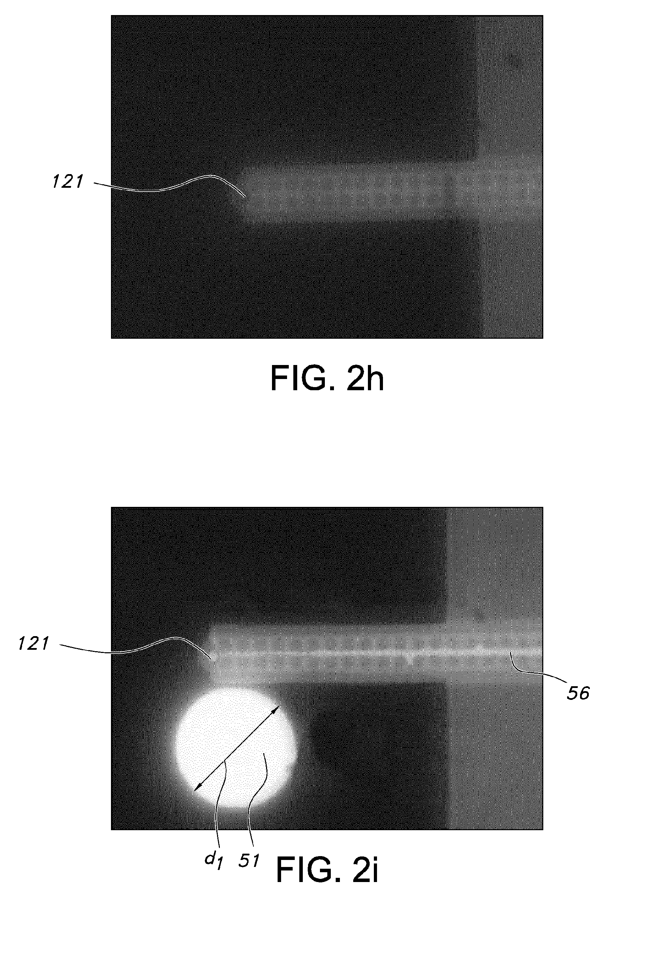

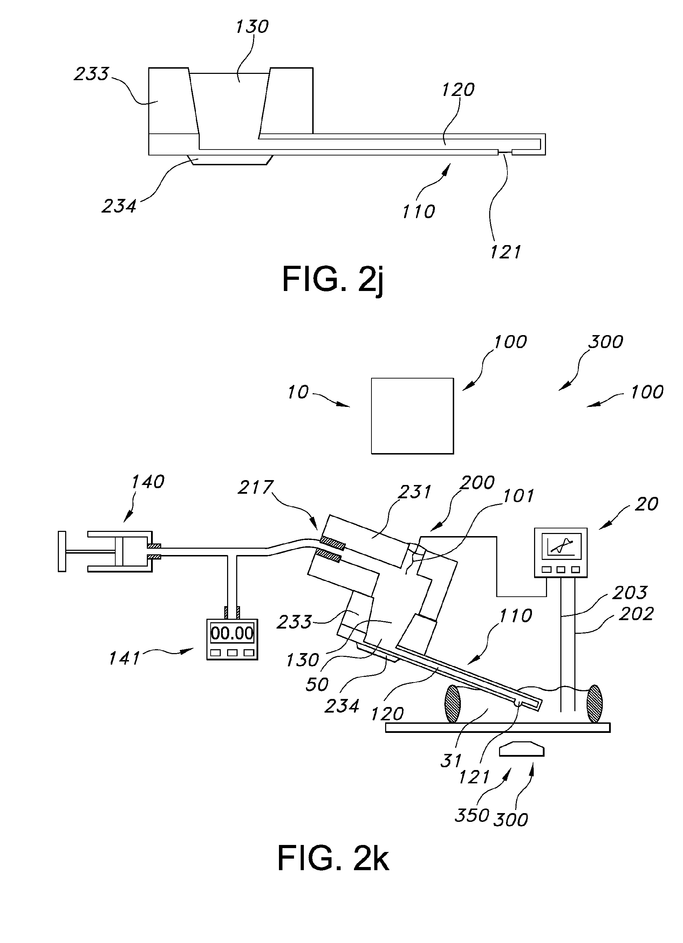

Figs. 2f-2g show optical microscopy pictures demonstrating the filling of the fountain pen probe with mercury in air; Fig. 2h and 2i show the corresponding photographs: optical microscopy of the fountain pen probe, showing the mechanically stabilizing pillars inside the empty capillary (2h) and demonstrating the filling of the fountain pen probe with mercury (2i): mercury drop at fountain (pen probe) aperture 121; mercury capillary 120 inside fountain pen probe; huge mercury drop 51 formed due to cohesion on an ITO substrate beneath and at a non-zero distance from the aperture 121, fed by the dropping mercury from the fountain pen aperture; Fig. 2j schematically shows an example (not to scale) of the fountain pen probe (side view, cross-section); Fig. 2k schematiccally (not to scale) shows an example of the experimental setup with the fluidic and electric connections. 140: pressure generator, here a syringe with mercury supply, 141: pressure sensor, 217: fluidic connector, 231: polycarbonate block, 110: cantilever, 202: electrode, such as an Ag wire; 203: electrode, such as a Pt wire, 20: control unit comprising electrochemical potentiostate, I: 350: inverted optical microscope; the microscope is used to observe the Hg flow and dropping better due to high optical magnification.
Fig. 3 shows the amperometric signal recorded at the dropping/stopped mercury fountain pen probe; 0.1 M NaClO₄; 0.1 V vs Ag wire (see also below);
Fig. 4 shows the amperometric signal recorded at the dropping/stopped mercury fountain pen probe; 0.1 M NaClO₄; 0.1 V vs Ag wire (see also below);
Fig. 5 shows the amperometric signal recorded at the static/stopped/dropping mercury fountain pen probe; 0.1 M NaClO₄; 0.1 V vs Ag wire; and
Fig. 6a shows the cyclic voltammogram recorded at a hanging mercury drop. 0.1 M NaCl); Fig. 6b shows a cyclic voltammogram recorded at a hanging mercury drop fountain pen probe; 1 mM ferrocenedimethanol in 0.1 M KCl recorded at 10 mVs⁻¹ scan rate; reference electrode: Ag/AgCl.

### DETAILED DESCRIPTION OF THE EMBODIMENTS

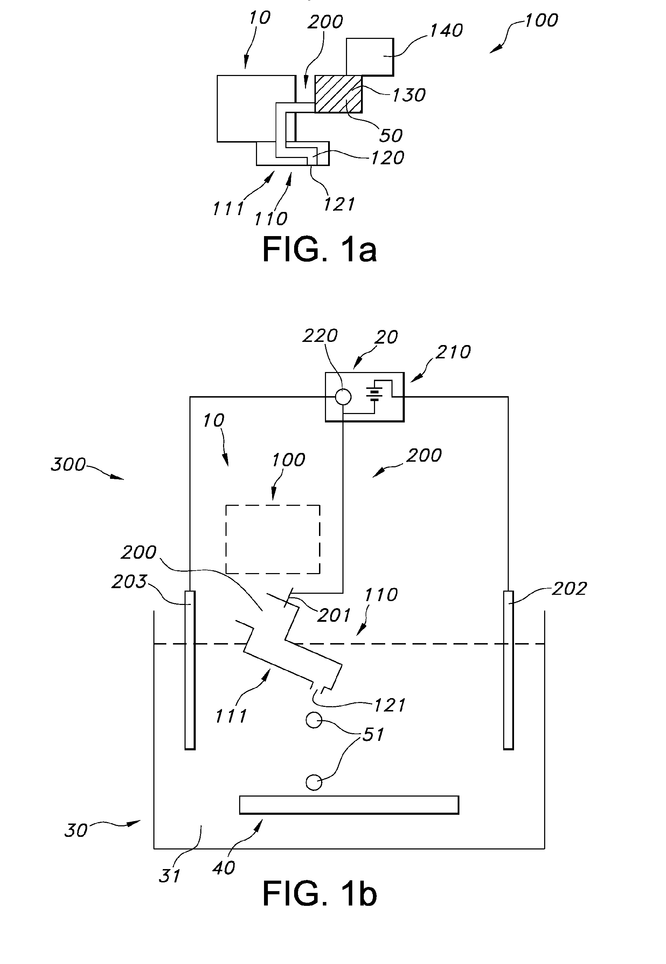

Figs. 1a-1b schematically depict an AFM setup 100 comprising an AFM cantilever 110. The cantilever 110 comprises a micro channel 120 with a cantilever micro channel outlet 121 for growing a mercury droplet. The channel outlet 121 may be an opening in a hollow tip of the cantilever or may be an opening in the cantilever (such as without a tip). In the latter embodiment, such opening or aperture may also be indicated as "pen probe aperture".

The micro channel 120 is part of a fluid system 200. The fluid system 200 further comprises a vessel 130 configured to contain mercury 50. The AFM setup 100 further comprises a pressure generator 140 configured to guide mercury 50 under a pressure of > 1 bar through the micro channel 120 to provide the mercury droplet at the cantilever micro channel outlet. Vessel 130 may be integrated in the cantilever or may be a separate vessel. Vessel 130 may also refer to a plurality of vessels, with e.g. one vessel integrated in the cantilever 110, and one or more vessels elsewhere in the AFM setup or AFM probe integrated dropping mercury electrode system (see fig. 1b). For instance, vessel 130 may be integrated in a probe head of the AFM.

Reference 111 indicates the cantilever arm, which substantially hosts the micro channel 120. Reference 10 very schematically depict other parts of the AFM setup, which are known to the person skilled in the art, and which may be present to perform AFM measurements, such as the AFM head, laser, sample stage and base of the instrument.

As can be seen, the micro channel 120 is part of a fluid system 200, which in this embodiment further comprises the vessel (or reservoir) 130 configured to contain mercury 50. The vessel 130 is upstream of the channel outlet 121, and in general also upstream of the cantilever arm 111.

Especially referring to fig. 1b, the fluid system 200 may further comprise a first electrode 101, configured to be in electrical contact with mercury 50 when mercury 50 is in the fluid system 200. Fig. 1b schematically depicts an embodiment of the AFM probe integrated dropping mercury electrode system 300 comprising the AFM setup 100, such as schematically depicted in fig. 1a. The AFM probe integrated dropping mercury electrode system 300 comprises the AFM setup 100, and may further includes a control unit 20, and one or more further electrodes. In such system 300, further a counter electrode 202 (like a Pt wire) and a reference electrode 203 (like an Ag wire) may be comprised. As reference electrode, Ag/AgCl may be applied; Ag may be applied as pseudo reference electrode. In addition, a voltage source 210 in electrical connection with the first electrode 101 and the counter electrode 202, and a sensor 220 configured to measure an electronic parameter selected from the group consisting of resistance, current and electrical potential difference between the first electrode 101 and the reference electrode 203 may be present. Again, details of the AMF, which are known to the person skilled in the art, are for the sake of clarity not included. The AFM setup is schematically depicted with reference 100, with the cantilever 110 in more detail.

The electrodes, including at least part of the cantilever, of which the mercury drops at the tip function as electrode, may be configured in a liquid 31, especially an electrolyte solution, such as 0.1 M KCl. The liquid 31 is contained in e.g. a vessel 30. The system 200 may be used to sense electric or conductive properties of an item 40, e.g. a self-assembled monolayer on a gold substrate. Fig. 1b schematically depicts an embodiment of an AFM probe integrated dropping mercury electrode.

Fig. 1b also shows a control unit 20, e.g. comprising an electrochemical potentiostate. For instance, this control unit may comprise a voltage source (in electrical connection with the first electrode 101 and the counter electrode 202, and a sensor 220 configured to measure an electronic parameter selected from the group consisting of resistance, current and electrical potential difference between the first electrode 101 and the reference electrode 203.

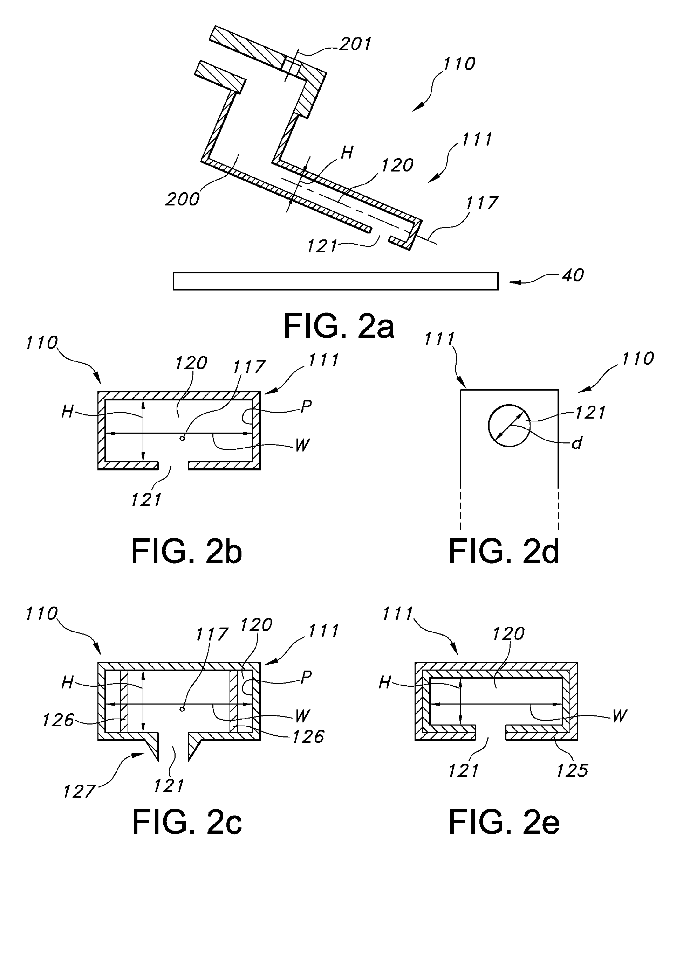

Fig. 2a schematically depicts a cantilever 110 in more detail, with cantilever arm 111. The micro channel 120 may have a length L, a height H, and a width W (see also figs. 2b, 2c and 2e). Figs. 2b-2e schematically depict some details of the cantilever 110. The cantilever used in the experiments had a length 150 µm, a width 36 µm, and a height of 3.9 µm; these are outer dimensions.

The dimensions of the channel were a length 150 µm, a width W of 24 µm, a height H of µm. Hence, the internal perimeter (P) is especially within the range of 4 nm - 100 µm (in this example 2*3 + 2*24 µm = 54 µm). The channel outlet hydraulic diameter d (i.e. diameter of outlet 121), see fig. 2d, was 4 or 8 µm. The shortest distance from the outlet 121 to the end of the cantilever arm was 7 µm. Reference 117 indicates the channel axis; cross-sections parallel to this channel axis 117 are schematically depicted in figs. 2b, 2c and 2d, wherein 2b schematically depicts and embodiment, or a cross-section without reinforcing bars, wherein fig. 2c schematically depicts and embodiment, or a cross-section with reinforcing bars 126, and by way of example also a cantilever tip 127 (with micro channel outlet 121), and fig. 2e schematically depicts and embodiment, or a cross-section wherein the micro channel 120 contains a coating 125. Hence, the wall(s) of the micro channel may be coated. The coating 125 may for instance be a fluorocarbon, such as Teflon, coating. Note that combinations of these embodiments may also be possible. For instance when referring to the embodiment of fig. 2c, the walls and the reinforcing bars may also be coated with a (fluorocarbon, such as Teflon,) coating 125. Fig. 2d schematically depicts an embodiment of part of the cantilever 110 when seen from below. At the end of the cantilever arm 111, the micro channel opening or outlet 121 is found, with diameter or channel outlet hydraulic diameter d. Note that the outlet may optionally also have another shape than circular (see also above). The perimeter of the outlet is πd. Would other type shaped outlets be used, the perimeter of such outlets will in generally be πd, with d selected from the range of 1 nm - 10 µm. Referring to fig. 2c, the internal reinforcing bars 126 are arranged perpendicular to a channel axis 117 of the micro channel 120. Note that the micro channel opening 121 is at a downstream part of the cantilever (arm).

Hence, we report here a novel type of "dropping/hanging-like" mercury electrode which is integrated into an AFM tip and cantilever. Our approach is based on a fountain pen probe with appropriate dimensions enabling filling with mercury under changing the applied pressure at a connected mercury supply. Dropping and hanging mercury drop at the AFM tip were observed as function of the applied pressure. The mercury flows through the hollow cantilever and forms drops of the size of ≥ 4 µm. The flow can be stopped under reduction of pressure and can be operated in hanging (HMDE) drop or continuously dropping configuration (DME). The hollow probe shows excellent isolation and electrical conductivity only occurs through the mercury. This was demonstrated by amperometric measurements in 0.1 M KCl electrolyte, as well as by mechanical contacting of an ITO substrate with a mercury filled and non-filled probe in air. Here an Ohmic contact was formed showing 133 Ω resistance in case of the Hg filled probe and 40 MΩ when Hg was absent, respectively. Finally, cyclic voltammetry was done in the hanging drop configuration demonstrating the usability of our mercury probe for fundamental electrochemical studies.

In the experiments, a fountain pen probe of specific dimension (and inner wall chemical surface modification) for the reversible filling with mercury was used. The usability of this device as "dropping" and "hanging" mercury electrode is demonstrated in an electrolyte environment. First, we describe the design and setup of the fountain pen based mercury electrode, see also fig. 1b, 1b and 2a, 2j and 2k.

The fountain pen probes were glued with UV glue to a specially designed polycarbonate block. By means of a fluidic Lee connector mercury was fed into the block and probe. Electrical contact to the mercury was provided by a platinum wire inside the polycarbonate block. The polycarbonate block with probe was connected to a linear translation motor, which could vary the height of the probe with respect to the substrate with a resolution of 1 µm. The probes were mounted under a slight angle. The whole setup was mounted on top of an inverted microscope (Leica DMI 5000 M). A transparent indium tin oxide (ITO) coated glass plate of 100 µm was used for the conductivity experiments. The resistance between the center of the ITO substrate and the connecting wire was 14-26 Ω. The electrolyte solution in which the electrochemical experiments were conducted was contained by a rubber ring placed on a glass plate. During the experiments a syringe mounted in a translation table was used to apply pressure to the mercury inside the tubing. The pressure inside the tubing was monitored with a pressure sensor (Sunx DP-102). A pressure of ~ 3 bar needed to fill a flat rectangular channel can be estimated based on the Young Laplace equation by 2*γ*cos(*θ*)/*h*. Here *θ* ≅ 137 +- 8° is the contact angle of the mercury to silicon nitride, *γ* = 487 mN/m is the surface tension of mercury, and *h ≅* 3 µm is the channel height. In fact we observed higher pressures in our experiments of ~6 bars needed to induce mercury flow due to the more complex fluidic system of our system including kinks and curvatures as well. The inverted microscope, linear translation motor and translation table were covered with plastic foil to protect it from possible mercury spills. For safety reasons the setup was placed under a fumehood.

A PalmSens handheld potentiostate (PalmSens, Utrecht, The Netherlands) was used for the electrochemical experiments which were carried out in a three-electrode arrangement. The AFM cantilever integrated mercury electrode was used as the working electrode. The reference (Ag wire) and counter (Pt wire) electrodes were immersed in the electrolyte solution as illustrated in figure 2k (or 1b). Electrochemical measurements were done in 0.1 M NaClO₄ or 0.1 M KCl. Chronoamperometry measurements were done at a working electrode potential of 0.1 V vs Ag. Cyclic voltammograms were recorded between 0 V and 0.4 V vs. Ag/AgCl with a scan rate of 10 mVs⁻¹.

In the work presented here we utilized a fountain pen probe of specific design and dimensions for the reversible filling with mercury under working pressures of ~ 6 bars. The principle usability of this device as dropping and static mercury type electrode was tested in an electrolyte environment. First, we describe the design and setup of the fountain pen based mercury electrode.

The fountain pen AFM probes used for the experiments are optimized for the application under significantly higher liquid pressure. A schematic of the probe is shown in 2j. The probe consists of a silicon nitride cantilever with embedded microchannel and a support block for handling. The microchannel in the cantilever connects the aperture at the end of the cantilever with a fluidic reservoir inside the block.

Typical dimensions of the probes are given in table 1. Thicknesses of the nitride layers, compromising the cantilever, were 470 nm.

**Table 1 Typical dimensions of the fountain pen probes.**

| | *Cantilever* | *Channel* |
|---|---|---|
| Length | 150 µm | 1300 µm |
| Width | 36 µm | 24 µm |
| Height | 3.9 µm | 3.0 µm |

The length of 1300 µm is the length of the channel upstream of the cantilever.

The aperture at the cantilever end was lithographically determined with a diameter of either 4 or 8 µm Inside the channel vertical pillars were added. These pillars provide mechanical stability to the channel when mercury fills it under a relative high applied pressure. To enhance withstanding to the mercury pressure the channel heights and walls were increased. Our experimental setup included an inverted optical microscope which allowed detailed observation of the mercury filling and flowing process of the fountain pen probe with mercury as function of the applied pressure (Fig. 2k; see below).

Figs 2f and 2g show optical microscopy pictures demonstrating the filling of the fountain pen probe with mercury in air; the former picture shows the unfilled system; the latter shows a filled system with a mercury droplet 51; the droplet has a diameter d1, which is here in the range of about 70 µm The cantilever shown was made of silicon nitride (SixNy; e.g. silicon rich silicon nitride might be applied). The mercury flows between the central pillars forming a capillary with less than 5 µm in width. This filling behavior is due to the non-wetting properties of the channel and pillar side-walls. A mercury drop can be seen with a size in the regime of the aperture. The huge drop is formed on the ITO surface due to cohesion and feeding via the dropping electrode. Importantly, upon filling and mercury flow any mechanical perturbation, for instance bending of the cantilever, could not be observed via optical microscopy, demonstrating the pivotal mechanical stability of our probe.

Fig. 2j schematically depicts an enlargement of an embodiment of the cantilever head with cantilever, such as schematically depicted in amongst others figs. 1a. The references indicated the same items as described above. Further, reference 233 refers to a vessel wall that may be for instance of glass. Reference 234 refers to a support, such as silicium The function of the support is to mechanically strengthen the cantilever. Fig. 2k schematically depicts an embodiment, like fig. 1b, of the AFM probe integrated dropping mercury electrode system 300.

In order to establish electrical contact of the fountain pen based mercury electrode, the probe was equipped with an electrical wire contact inside, which immersed into the mercury filling and which was connected to a voltmeter and to an electrochemical potentiostate for the electrochemical experiments.

To proof electrical conductivity of the mercury fountain pen probe it was mechanically contacted to a transparent indium-tin oxide (ITO) substrate. A high ohmic resistance of 40 MΩ (maximum value of the voltmeter used) was found indicating good isolating properties of the fountain pen probe. Upon filling with mercury a dramatic drop in resistance to 133 Ω occurred as the mercury flew out of the opening and contacted/wetted the ITO. We conclude that electrical conductivity is maintained via the mercury inside the fountain pen probe while the hollow fountain pen probe itself reveals excellent electrical isolation.

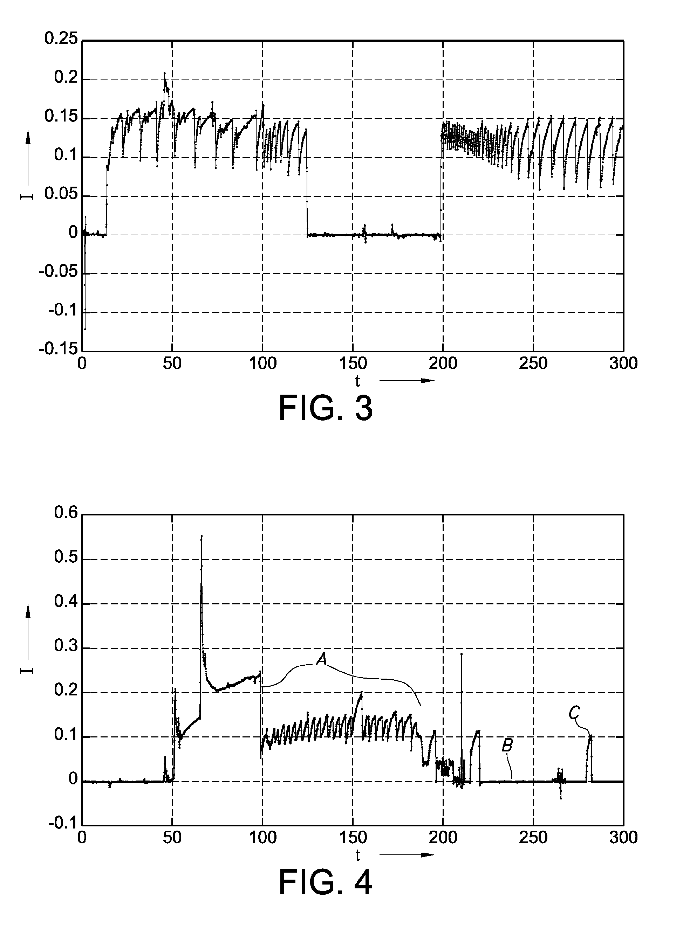

The usability and performance of the mercury fountain pen probe as electrochemical electrode was tested in 0.1 M NaClO₄. A potential of 0.1 V was applied to the mercury probe vs. a silver wire. As counter electrode a platinum wire was used. The current at the mercury probe was recorded as function of time and as function of the pressure applied to the mercury. Initially no current was observed (Fig. 3) as explained by the empty fountain pen probe. Increasing the pressure to ~6 bar at the external mercury supply, a sudden current onset was recorded at a time of ~ 10 s as a result of mercury filling and dropping into the electrolyte. The current increased but with decreasing rate until a maximum current of 0.15 µA followed by a sharp drop to 0.1 µA and immediate current increase to a saturation value and repeated dropping as observed at conventional macroscopic dropping mercury electrodes. As there was no electroactive species present the observed current response was due to a capacitive charging of the electric double layer, the mercury drop growth related to its continuous dropping. Mercury drop lifetimes were in the regime of a few s to ~10 s while the currents observed under mercury dropping ranged between 0.05 µA (minimal value) to 0.16 µA (maximal value (exceptional: 0.21 µA)). Continuous dropping of the mercury electrode was observed as recorded in the current response, complementing the observations made with an inverted optical microscope. Reducing the pressure again under the critical value effected abrupt stop of mercury flow accompanied with instantaneous drop of the current to zero. After ca. 1 min the pressure at the mercury supply was raised again above the critical value leading to the onset of mercury dropping again, as observed by the chronoamperometric response.

It is referred to Fig. 3 (x-axis time (s); y-axis current (µA)), wherein the Amperometric signal recorded at the dropping/stopped mercury fountain pen probe; 0.1 M NaClO₄; 0.1 V vs. Ag wire is depicted.

This demonstrates in a proof of concept experiment the principle controllability of flow and stop of flow of the mercury through the fountain pen probe. Importantly, leakage currents cannot be observed. This is an absolute prerequisite to enable probing of local electrochemistry. A high signal to noise ratio can thus be expected. We could further achieve conditions were the mercury droplet remained hanging at the probe thus resembling a "HDME"-like configuration. In this case cyclic voltammograms were recorded (fig. 4).

The formation of single drops was observed as well. It is referred to Fig 4 (x-axis time (s); y-axis current (µA)), wherein the Amperometric signal recorded at the dropping/stopped mercury fountain pen probe; 0.1 M NaClO₄; 0.1 V vs. Ag wire is depicted. Reference A indicates "continuous dropping"; reference B indicates a period wherein no drops are generated; reference C indicates a single drop.

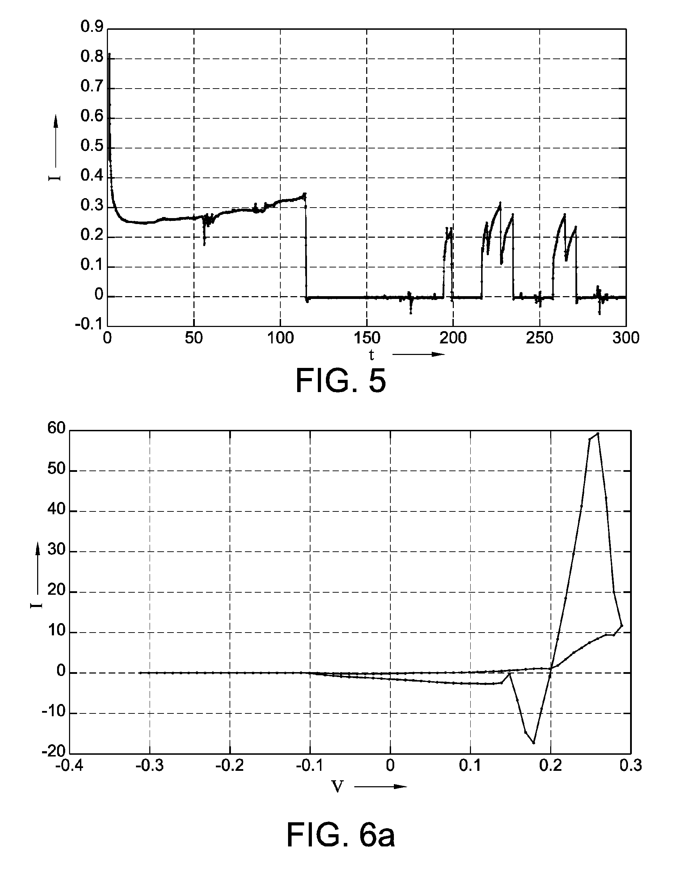

The time trace between 70~98 s of the chronoamperometry indicates the presence of a single droplet (static) at the probe. Previously observed spikes are due to the filling process/mercury contacting inside the fountain pen probe. It is referred to Fig 5 (x-axis time (s); y-axis current (µA)), wherein the Amperometric signal recorded at the static/stopped/dropping mercury fountain pen probe; 0.1 M NaClO₄; 0.1 V vs. Ag wire is depicted.

We could further achieve conditions where the mercury droplet remained hanging at the probe as confirmed by optical microscopy, resembling a hanging mercury drop configuration (see also above).

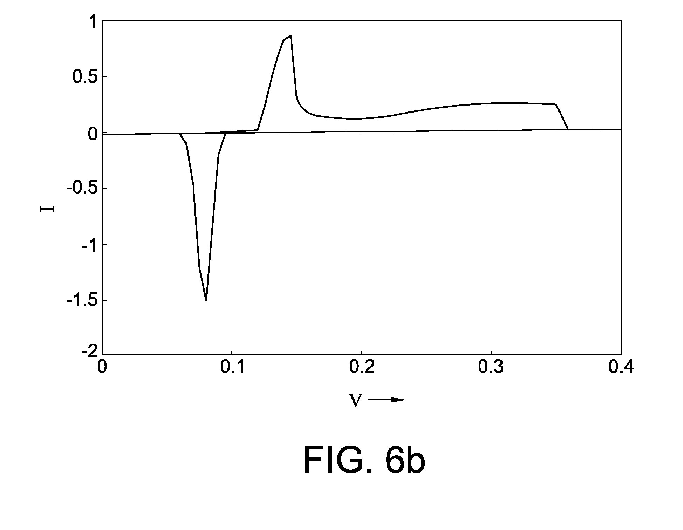

Further, cyclic voltammetry measurements were done, which are shown in Fig. 6a. Fig. 6a (x-axis voltage (V); y-axis current (µA)), wherein the Cyclic Voltammogram recorded at a hanging mercury drop. 01 M NaCl) is depicted. A further hanging drop like configuration cyclic voltammetry was done (Fig. 6b) of 1 mM ferrocenedimethanol in 0.1 M KCl demonstrating the principle usability of the mercury probe for electrochemical studies.

Hence, we introduce a novel type of mercury electrode integrated into an AFM cantilever enable simultaneous electrochemistry and AFM measurements (AFM-SECM). Mercury flows through a hollow cantilever and forms drops of the size of e.g. about 10 um, flow can be stopped, can be operated in hanging drop or continuously dropping. Electrical conductivity only occurs through the mercury. Chronoamperomety and voltammetry measurements were done in electrolyte demonstrating the usability for fundamental electrochemical studies. Therefore, the invention allows an AFM tip/probe integrated hanging and dropping mercury (micro) electrode. However, the invention also allows an AFM with integrated (renewable) fluid/liquid metallic conductor. Yet, the invention also allows an approach to fill/exchange/renew a liquid metal/mercury into a fountain pen and/or AFM lithography with mercury and liquid metals/alloys (Amalgam). Therefore, we introduce a novel type of mercury electrode based on a fountain pen probe. To the best of our knowledge an in-situ renewable mercury electrode integrated into an AFM cantilever has not been reported in the literature. In proof of principle experiments chronoamperometry and cyclic voltammetry measurements were done in electrolyte testing the principle usability for electrochemical studies. Essentially stabilization of the dropping process and its control are further needed. This includes the configuration of a sophisticated pumping system to fine control the mercury liquid pressure, and to enable homogeneous wetting and flow inside the capillary. Our results enable to further integrate the in-situ renewable mercury electrode into the AFM setup, in particular to enable combined AFM electrochemical measurements to simultaneously probe forces and electrical/electrochemical signals. This might open novel avenues in areas where mechanics is coupled to electrochemical or electrical properties, for instance in particle electrochemistry. Moreover our probe might find use to locally deliver mercury to form an amalgam on a metal surface, which goes beyond electroanalytical applications. In principle other liquid metals or liquid metal alloys could be utilized in this regard as well. Moreover, our probe might find use to locally measure or map conductivities on surfaces or self-assembled monolayers for molecular electronics applications.

Below, some information is given on an embodiment of the microfabrication process of the fountain pen probe:
● A (low stress) silicon rich nitride layer is deposited by LPCVD (Low Pressure Chemical Vapour Deposition) on a blank silicon wafer.
● By means of lithography the aperture is defined and etched into the first silicon nitride layer.
● A sacrificial layer of polysilicon is deposited by LPCVD. This layer is patterned and outlines the inner part of the channel.
● With LPCVD a second layer of silicon rich nitride is deposited. This layer forms the top layer of the channel.
● In the top nitride layer an opening is defined for the connection with the fluidic reservoir. Also a significant part of the top of the channel (inside the handling block) is partly opened. (This reduces the time required for the sacrificial layer etch inside the channel later on).
● A glass wafer is bonded on top of the nitride layer. The fluidic reservoir and handling block outline is powder blasted in this glass wafer.
● A silicon etch step removes the sacrificial layer inside the channel and removes large part of the bottom silicon wafer. After etching only a small part of silicon wafer remains underneath the liquid reservoir. This part protects the fragile membrane and makes it easier to handle the probe.

## Claims

1. A method of performing a dropping mercury based process on a microscopic scale, the method comprising providing an AFM (atomic force microscopy) setup (100) with an AFM cantilever (110) comprising a micro channel (120) with a cantilever micro channel outlet (121) for growing a mercury droplet (51) having mercury droplet dimensions, and guiding mercury (50), under a pressure, through the micro channel (120) to provide the mercury droplet (51) at the cantilever micro channel outlet (121), wherein the cantilever micro channel outlet (121) has an channel outlet hydraulic diameter (d) selected from the range of 1 nm - 10 µm, and wherein the micro channel (120) of the AFM cantilever (110) has a hydraulic diameter (Dh) in the range of 1 nm - 100 µm, wherein the micro channel (120) is part of a fluid system (200), wherein the fluid system (200) further comprises a first electrode (101) configured to be in contact with the mercury (50) in the fluid system (200) during operation of the AFM setup (100), and wherein by controlling the pressure one or more of (a) the mercury droplet (51) can be removed from the micro channel outlet (121) and replaced by a new mercury droplet (51), and (b) the dimensions of the mercury droplet (51) can be controlled.

2. The method according to claim 1, wherein the micro channel (120) of the AFM cantilever (110) comprises internal reinforcing bars (126) arranged perpendicular to a channel axis of the micro channel (120).

3. The method according to any one of the preceding claims, wherein the micro channel (120) of the AFM cantilever (110) has a hydraulic diameter (Dh) in the range of 10-50 µm.

4. The method according to any one of the preceding claims, wherein the micro channel (120) of the AFM cantilever (110) is at least partly coated with a fluorocarbon coating or a metal coating.

5. The method according to any one of the preceding claims, wherein the dropping mercury based process is an electrochemical process, and wherein the micro channel (120) is part of a fluid system (200), wherein the fluid system (200) further comprises a first electrode (101) configured to be in contact with the mercury in the fluid system (200) during operation of the AFM setup (100).

6. The method according to any one of the preceding claims, comprising guiding mercury (50) under a pressure in the range of 2-100 bar through the micro channel (120).

7. The method according to any one of the preceding claims, wherein the mercury (50) is guided under a pressure ≥ 4 bar through the micro channel (120) to provide the mercury droplet (51).

8. Use of the method according to any one of the preceding claims for one or more applications selected from the group consisting of: (1) probing conductivity of a heterogeneous substrate, (2) Hg lithography, (3) electrochemically probing a local concentration of a specie, and (4) simultaneously electrochemical probing and atomic force probing of a surface.

9. An AFM setup (100) comprising an AFM cantilever (110) comprising a micro channel (120), with a cantilever micro channel outlet (121) for growing a mercury droplet (51), wherein the cantilever micro channel outlet (121) has an channel outlet hydraulic diameter (d) selected from the range of 1 nm - 10 µm, wherein the micro channel (120) of the AFM cantilever (110) has a hydraulic diameter (Dh) in the range of 1 nm - 100 µm, wherein the micro channel (120) is part of a fluid system (200), wherein the fluid system (200) further comprises a vessel (130) configured to contain mercury (50), and wherein the AFM setup (100) further comprises a pressure generator (140), configured to guide mercury (50) under a pressure of ≥ 1 bar through the micro channel (120) to provide the mercury droplet (51) at the cantilever micro channel outlet (121).

10. The AFM setup (100) according to claim 9, wherein the micro channel (120) of the AFM cantilever (110) is at least partly coated with a fluorocarbon coating or a metal coating.

11. The AFM setup (100) according to any one of claims 9-10, wherein the micro channel (120) of the AFM cantilever (110) has a hydraulic diameter (Dh) in the range of 1 nm - 100 µm.

12. The AFM setup (100) according to any one of claims 9-1 l, wherein the micro channel (120) of the AFM cantilever (110) comprises internal reinforcing bars (126) arranged perpendicular to a channel axis of the micro channel (120).

13. The AFM setup (100) according to any one of claims 9-12, wherein the fluid system (200) further comprises a first electrode (101), configured to be in electrical contact with mercury (50) when mercury (50) is in the fluid system (200).

14. An AFM probe integrated dropping mercury electrode system (300) comprising the AFM setup (100) according to claim 13, a counter electrode (202), a reference electrode (203), a voltage source (210) in electrical connection with the first electrode (101) and the counter electrode (202), and a sensor (220) configured to measure an electronic parameter selected from the group consisting of resistance, current and electrical potential difference between the first electrode (101) and the reference electrode (203).

15. Use of the AFM setup (100) according to any one of claims 9-13 or the AFM probe integrated dropping mercury electrode system (300) according to claim 14, in an analysis process wherein the AFM cantilever (110) is used as dropping or hanging mercury electrode.
